# EUROPEAN PATENT APPLICATION

(11) **EP 0 949 462 A1**
(43) Date of publication of application: **13.10.1999**
(21) Application number: 97911483.2
(22) Date of filing: 07.11.1997
(51) Int. Cl.: F25B 21/02, F25D 11/00

(54) **LIQUID FEEDING METHOD FOR THERMOELECTRIC COOLING SYSTEMS**

(30) Priority: 08.11.1996 JP 29627096
(71) Applicant: MATSUSHITA REFRIGERATION COMPANY, Higashiosaka-shi, Osaka 577 (JP)
(72) Inventor: TOKUNAGA, Shigetomi, Otsu-shi, Shiga 520-22 (JP); MAEDA, Munekazu, Yao-shi, Osaka 581 (JP); KITAGAWA, Hiroaki, Otsu-shi, Shiga 520-21 (JP); NAKAGAWA, Osamu, Kouka-gun, Shiga 520-32 (JP)
(74) Representative: Eisenführ, Speiser & Partner
(86) International application number: JP9704061
(87) International publication number: WO9821530

(57) **Abstract**

A liquid suction port 34 between a heat-radiating heat exchanger 10 and a heat exchanging portion 26a of a manifold is connected to a liquid tank 51, and a self-priming pump 52 is connected to a suction port or discharge port of a circulating pump 14a in series. Then, the self-priming pump 52 is operated to pump a liquid from the liquid tank 51. After the liquid has reached a discharge port of the self-priming pump 52, the operation of the self-priming pump 52 is stopped and the liquid suction port 34 is closed. Finally, the self-priming pump 52 is removed and a coupling port between the self-priming pump 52 and the circulating passage is closed.

## Description

### Technical Field

The present invention relates to a thermoelectric refrigeration system using a Peltier element and, more particularly, to a liquid filling method in a thermoelectric refrigeration system employed in an electric refrigerator or the like.

### Background Art

A technique of use of the Peltier element in a refrigeration system is disclosed in a PCT Japanese patent publication No. 6-504361. According to this known technique, the Peltier element has a heat radiating surface and a cooling surface each thermally coupled with a coolant passage through which a liquid coolant is forcibly circulated. By so doing, an object can be cooled by a heat exchanger disposed on the coolant passage thermally coupled with the cooling surface of the Peltier element, or can be heated by a heat exchanger disposed on the coolant passage thermally coupled with the heat radiating surface of the Peltier element.

However, in order to realize an electric refrigerator by the use of the above discussed technique, problems have been encountered to further increase the heat efficiency and also to avoid inclusion of air bubbles in the liquid coolant that is filled in the coolant passages.

Then, it is conceivable to employ a liquid filling method wherein with the coolant passages held in vacuum, the coolant passages are partially immersed in a liquid coolant, in which condition the coolant immersed portion of the coolant passages is opened for drawing the liquid coolant into the coolant passages.

However, if this filling method is carried out, the impact which may be caused in drawing the liquid coolant would affect the coolant passages, and this would result in coolant leakage unless various junctions of the coolant passages are of rigid construction.

The present invention has been developed in view of such problems inherent in the prior art, and it is an objective of the present invention to provide a liquid filling method in a thermoelectric refrigeration system which does not require any such mechanical strength with respect to the coolant passages as is greater than that necessary for normal refrigerator operation, and yet enables coolant filling with little bubble inclusion involved.

### Disclosure of the Invention

In accomplishing the above objective, the present invention provides a liquid filling method in a thermoelectric refrigeration system which is characterized in that a circulating passage is filled with a liquid coolant by drawing up the liquid coolant with the use of a self-priming pump, by causing the liquid coolant to flow downward, or by pumping the liquid coolant under pressure.

According to the present invention, it is possible to carry out coolant filling with little bubble inclusion involved, and without requiring any such mechanical strength with respect to the circulating passage as is greater than that necessary for normal refrigerator operation.

Specifically, a thermoelectric refrigeration system includes a first heat exchanging portion thermally coupled to a heat radiating surface of a thermoelectric module, a second heat exchanging portion thermally coupled to a cooling surface of the thermoelectric module, and at least one of a heat radiating system and a heat absorbing system. The heat radiating system includes a first circulating passage defined by a first circulating pump, a heat-radiating heat exchanger and the first heat exchanging portion, with a liquid filled in the first circulating passage. The heat absorbing system includes a second circulating passage defined by a second circulating pump, a cooling heat exchanger and the second heat exchanging portion, with a liquid filled in the second circulating passage. The liquid filling method comprises: when either the first or second circulating passage is filled with the liquid, connecting to a liquid tank a liquid suction port between the heat exchanger and the first or second heat exchanging portion, connecting a self-priming pump to a suction port or discharge port of the circulating pump in series, operating the self-priming pump to draw the liquid from the liquid tank through the circulating passage, stopping the operation of the self-priming pump after the liquid has reached a discharge port of the self-priming pump, closing the liquid suction port, removing the self-priming pump, and closing a coupling port between the self-priming pump and the circulating passage.

According to this arrangement, when the self-priming pump is operated, the liquid is drawn up through the passage extending from the heat exchanger to the circulating pump and the passage extending from the first or second heat exchanging portion to the circulating pump so as not to allow any bubble inclusion. When operation of the self-priming pump is stopped, the liquid filled is prevented from flowing downward from the liquid suction port. Under this condition, the liquid suction port is closed and the self-priming pump is removed. Then, the coupling port between the self-priming pump and the circulating passage is closed before liquid filling is completed.

Alternatively, in a thermoelectric refrigeration system including: a first heat exchanging portion thermally coupled to a heat radiating surface of a thermoelectric module; a second heat exchanging portion thermally coupled to a cooling surface of the thermoelectric module; and at least one of a heat radiating system including a first circulating passage defined by a first circulating pump, a heat-radiating heat exchanger and the first heat exchanging portion, with a liquid filled in the first circulating passage, and a heat absorbing system including a second circulating passage defined by a second circulating pump, a cooling heat exchanger and the second heat exchanging portion, with a liquid filled in the second circulating passage, the liquid filling method comprises: when either the first or second circulating passage is Filled with the liquid, arranging a first three-way valve and a second three-way valve in series in the circulating passage, causing the liquid to flow from the first three-way valve through the circulating passage and the second three-way valve under the condition in which no communication between the first and second three-way valves is allowed, switching the first and second three-way valves to close the circulating passage so that the liquid is prevented from flowing into and out of the circulating passage, thus allowing the liquid to flow from the first three-way valve to the second three-way valve to fill the liquid in a connecting pipeline between the first three-way valve and the second three-way valve, and further switching the first and second three-way valves so that the circulating passage is formed with the first and second three-way valves before liquid filling is completed.

According to this arrangement, three-step switching of the first and second three-way valves enables the liquid to be filled into the circulating passage by pressure-feeding, sucking or downward flow.

Preferably, prior to the start of filling of the object liquid, a pretreatment agent for improving the inner surface condition of the circulating passage is drawn up by driving a self-priming pump, and thereafter the object liquid is drawn up to thereby complete the filling operation.

According to this arrangement, the pretreatment agent acts to remove any inner surface irregularity of the circulating passage to smooth the inner surface thereof. When the liquid filling is subsequently started, a considerably reduced amount of air bubbles would adhere to the smoothed inner surface of the circulating passage.

Specifically, a silica-containing acrylic resin coating or a surface active agent may be used as the pretreatment agent.

### Brief Description of the Drawings

Fig. 1 is a longitudinal sectional view of an electric refrigerator to which is applied a liquid filling method in a thermoelectric refrigeration system according to a first embodiment of the present invention;
Fig. 2 is a perspective view of the electric refrigerator of Fig. 1;
Fig. 3 is a partially cut-away rear elevation of the electric refrigerator of Fig. 1;
Fig. 4 is a horizontal sectional view of an upper portion of the electric refrigerator of Fig. 1;
Fig. 5 is a perspective view showing a heat-radiating heat exchanger and a circulating pump both provided in the electric refrigerator of Fig. 1;
Fig. 6 is an explanatory view for explaining a heat radiating cycle and a heat absorbing cycle in the electric refrigerator of Fig. 1;
Fig. 7 is a perspective view of component parts forming a heat radiating cycle;
Fig. 8 is a perspective view of component parts forming a heat absorbing cycle;
Fig. 9 is a side view showing the manner in which an air trap is fitted to the circulating pump;
Fig. 10 is a longitudinal sectional view of an ice-making portion used in the electric refrigerator of Fig. 1;
Fig. 11 is a perspective view showing component parts shown in Fig. 7 when a liquid coolant is being introduced thereinto;
Fig. 12 is a perspective view showing component parts shown in Fig. 8 when the liquid coolant is being introduced thereinto;
Fig. 13 is a perspective view showing component parts forming a heat radiating cycle to which is applied the liquid filling method in the thermoelectric refrigeration system according to the second embodiment of the present invention, with the liquid coolant being introduced into the component parts;
Fig. 14A is a schematic piping system diagram in which operation of two three-way valves shown in Fig. 13 causes the liquid coolant to be supplied into a heat-radiating heat exchanger, a circulating pump and the like;
Fig. 14B is a schematic piping system diagram showing the two three-way valves as switched over from one to the other so that the liquid coolant is fed into a pipeline extending between the three-way valves;
Fig. 14C is a schematic piping system diagram showing the two three-way valves as switched over again after completion of the coolant filling; and
Fig. 15 is a perspective view showing component parts forming a heat absorbing cycle, to which the second embodiment of the present invention is applied, as viewed when the liquid coolant is supplied into the component parts.

### Best Mode For Carrying Out The Invention

Hereinafter, the liquid filling method in the thermoelectric refrigeration system of the present invention will be described, taking the case of an electric refrigerator of the thermoelectric module type.

### (Embodiment 1)

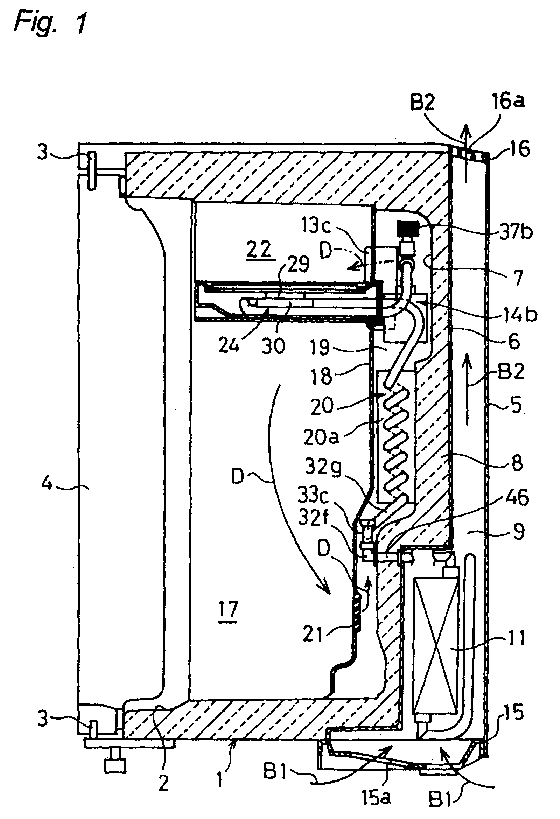

Figs. 1 to 12 illustrate the first preferred embodiment of the present invention.

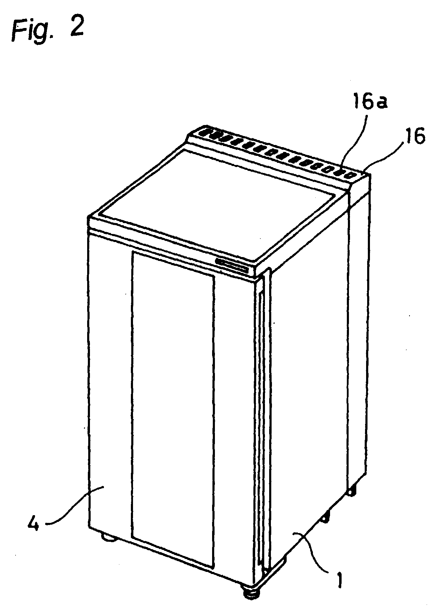

As shown in Figs. 1 and 2, an electric refrigerator comprises a refrigerator cabinet 1 having a front opening 2 defined therein, and a front door 4 hingedly supported by a shaft 3 for selectively opening and closing the front opening 2. The refrigerator cabinet 1 includes a rear wall 5 closing a rear opening thereof, a partition wall 6 positioned inside and secured to the refrigerator cabinet 1 while spaced a distance inwardly from the rear wall 5, and a chamber defining structure 7 positioned inside the refrigerator cabinet 1, with an insulating material 8 packed in a space between the partition wall 6 and the chamber defining structure 7.

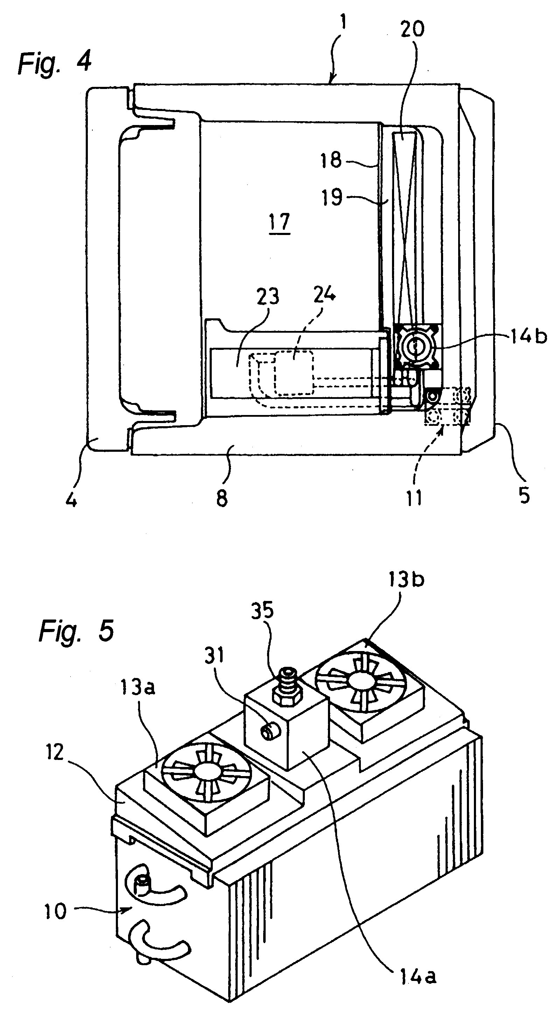

As shown in Figs. 1, 3 and 4, an outdoor chamber 9 defined between the rear wall 5 and the partition wall 6 accommodates therein a heat-radiating heat exchanger 10, positioned at a lower region of the outdoor chamber 9, and a primary manifold 11 as will be described later. Fan drive motors 13a and 13b are mounted atop the heat-radiating heat exchanger 10 through a hood 12 as shown in Fig. 5. A first circulating pump 14a is mounted on an upper face of the hood 12 and between the fan drive motors 13a and 13b.

A lower grille 15 having suction openings 15a defined therein is fitted to the bottom of the outdoor chamber 9, and an upper grille 16 having discharge openings 16a defined therein is fitted to the top of the outdoor chamber 9. Air drawn into the outdoor chamber 9 through the suction openings 15a in the lower grille 15 when the fan drive motors 13a and 13b are driven flows through fins of the heat-radiating heat exchanger 10 and is then discharged to the outside through the discharge openings 16a in the upper grille 16.

An indoor chamber 17 defined inside the chamber defining structure 7 has a partition wall 18 installed inside the chamber defining structure 7 so as to define a machine chamber 19 in which a cooling heat exchanger 20 and a second circulating pump 14b positioned above the cooling heat exchanger 20 are accommodated. A fan drive motor 13c is mounted atop the partition wall 18, and suction ports 21 are defined in a lower region of the partition wall 18. Air inside the indoor chamber 17 is, when the fan drive motor 13c is driven, drawn into the machine chamber 19 through the suction openings 21 in the partition wall 18 and is, after having passed through fins 20a of the cooling heat exchanger 20, circulated by the fan drive motor 13c back into the indoor chamber 17.

As shown in Figs. 1 and 4, an upper portion of the indoor chamber 17 defines an ice chamber 22 including an ice making plate 23, and an auxiliary manifold 24 as will be described later is fitted to a rear portion of the ice making plate 23.

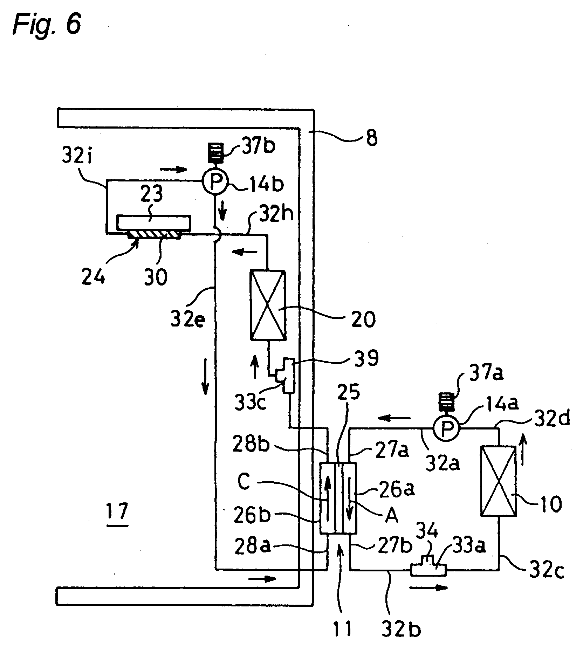

The primary manifold 11 referred to above includes, as shown in Fig. 6, a Peltier element 25 as a thermoelectric module, a first heat exchanging portion 26a thermally coupled with a heat radiating surface of the Peltier element 25, and a second heat exchanging portion 26b thermally coupled with a cooling surface of the Peltier element 25. When a liquid coolant is supplied from one end 27a of the first heat exchanging portion 26a, the liquid coolant can absorb heat radiating from the heat radiating surface of the Peltier element 25, accompanied by an increase in temperature of the liquid coolant which subsequently flows outwardly from the opposite end 27b of the first heat exchanging portion 26a. When a liquid coolant is supplied from one end 28a of the second heat exchanging portion 26b, heat can be transmitted to the cooling surface of the Peltier element 25, resulting in decrease of the temperature of the liquid coolant which subsequently flows outwardly from the opposite end 28b of the second heat exchanging portion 26b.

The auxiliary manifold 24 is similar to the primary manifold and includes a Peltier element 29 as a thermoelectric module, a third heat exchanging portion 30 thermally coupled with a heat radiating surface of the Peltier element 29. The ice making plate 23 referred to previously is held in contact with and is therefore thermally coupled with a cooling surface of this Peltier element 29.

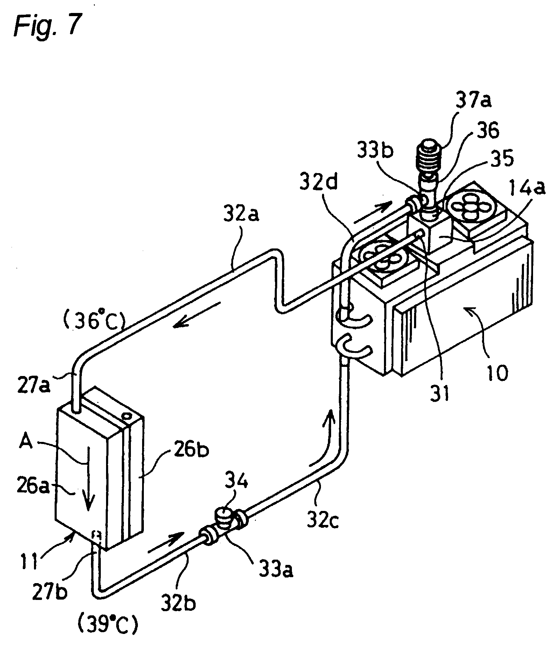

A first circulating passage of a heat radiating system for circulating the liquid coolant from the first circulating pump 14a back to the first circulating pump 14a via the heat-radiating heat exchanger 10 and the first heat exchanging portion 26a of the primary manifold 11 is so designed as shown in Fig. 7.

The first circulating pump 14a has a discharge port 31 fluid-connected with the end 27a of the first heat exchanging portion 26a of the primary manifold 11 through a first piping 32a, and the other end 27b of the first heat exchanging portion 26a of the primary manifold 11 and one end of the heatradiating heat exchanger 10 are fluid-connected with each other through second and third pipings 32b and 32c with a generally T-shaped fluid coupler 33a interposed therebetween. A remaining coupling port 34 of the T-shaped fluid coupler 33a is finally closed by a cap.

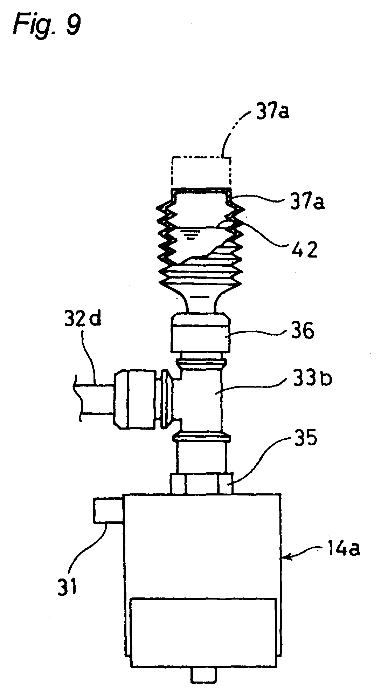

The opposite end of the heat-radiating heat exchanger 10 and a suction port 35 of the first circulating pump 14a are fluid-connected together through a fourth piping 32d and a generally T-shaped fluid coupler 33b. A remaining coupling port 36 of the T-shaped fluid coupler 33b is finally fitted with a first air trap 37a expandable between a solid-lined position and a phantom-lined position as shown in Fig. 9.

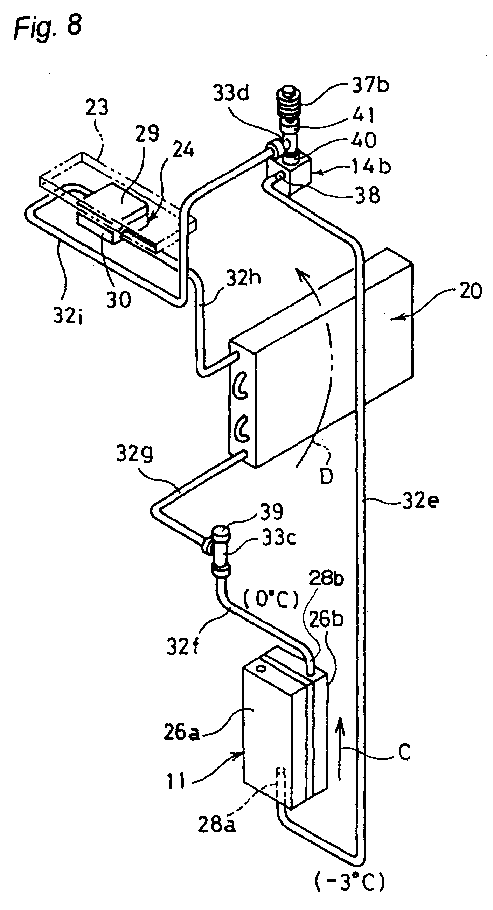

A second circulating passage of the heat absorbing system for circulating the liquid coolant from the second circulating pump 14b back to the second circulating pump 14b via the cooling heat exchanger 20 and the second heat exchanging portion 26b of the primary manifold 11 is so designed as shown in Fig. 8.

The second circulating pump 14b has a discharge port 38 fluid-connected with one end 28a of the second heat exchanging portion 26b of the primary manifold 11 through a fifth piping 32e, and the other end 28b of the second heat exchanging portion 26b of the primary manifold 11 and one end of the cooling heat exchanger 20 are fluid-connected with each other through sixth and seventh pipings 32f and 32g with a generally T-shaped fluid coupler 33c interposed therebetween. A remaining coupling port 39 of the T-shaped fluid coupler 33c is finally closed by a cap.

The opposite end of the cooling heat exchanger 20 and one end of the third heat exchanging portion 30 of the auxiliary manifold 24 are fluid-connected together through an eighth piping 32h, and the opposite end of the third heat exchanging portion 30 of the auxiliary manifold 24 and a suction port 40 of the second circulating pump 14b are fluid-connected together through a ninth piping 32i and a generally T-shaped fluid coupler 33d interposed therebetween. A remaining coupling port 41 of the T-shaped fluid coupler 33d is finally fitted with a second air trap 37b similar to the first air trap 37a.

It is to be noted that although not shown, the primary manifold 11 is in practice covered with a heat insulating material.

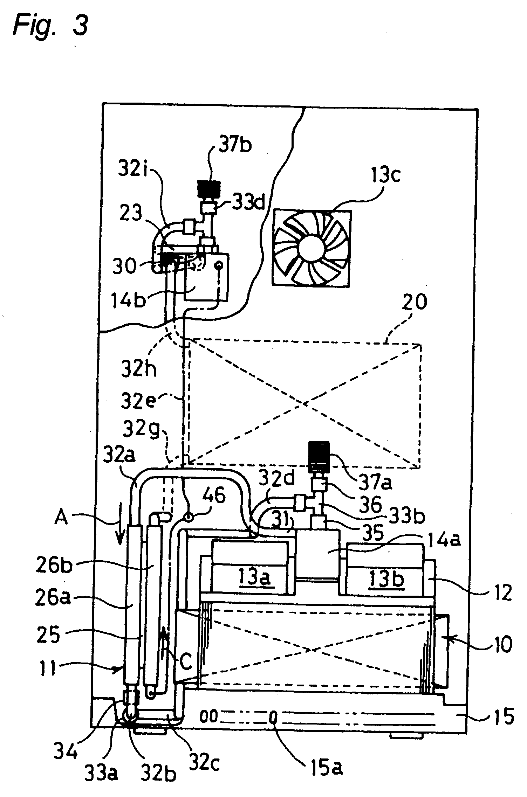

Thus, by designing the first and second circulating passages in the manner described above, filling the liquid coolant such as a mixture of propylene glycol and water, initiating supply of an electric power to the Peltier elements 25 and 29 of the primary and auxiliary manifolds 11 and 24, driving the first and second circulating pumps 14a and 14b, and driving the fan drive motors 13a, 13b and 13c, the liquid coolant flowing downwardly through the first heat exchanging portion 26a of the primary manifold 11 as shown by the arrow A in Figs. 3 and 7 is heated by heat generated from the heat radiating surface of the Peltier element 25, and the heated liquid coolant dissipates heat during the flow through the heat-radiating heat exchanger 10, accompanied by reduction in temperature and, is thereafter, returned back to the first heat exchanging portion 26a of the primary manifold 11 to thereby complete a heat radiating cycle during which a stream of air B1 sucked through the lower grille 15 and heat radiated from the heat radiating surface of the Peltier element 25 are heat-exchanged in the heat-radiating heat exchanger 10 to produce a heated stream of air B2 which is then discharged to the atmosphere through the upper grille 16.

Also, the liquid coolant flows upwardly through the second heat exchanging portion 26b of the primary manifold 11 as shown by the arrow C in Figs. 3 and 8 and the liquid coolant which has been cooled in contact with the cooling surface of the Peltier element 29 with a temperature thereof consequently reduced is heat-exchanged during the flow through the cooling heat exchanger 20 with the circulated air D within the indoor chamber 17 to thereby cool the indoor chamber 17, and the liquid coolant during the flow through the third heat exchanging portion 30 of the auxiliary manifold 24 is again heat-exchanged in contact with the heat radiating surface of the Peltier element 29, accompanied by increase in temperature thereof and is then returned to the second heat exchanging portion 26b of the primary manifold 11, thereby completing a heat absorbing cycle.

More specifically, when the system was operated to refrigerate the indoor chamber 17 of 60 litters in volume to 5°C while the outdoor temperature was 30°C, the temperature of the liquid coolant at an inlet side (the end 27a) of the first heat exchanging portion 26a of the primary manifold 11 was 36°C and the liquid coolant at an exit side (the opposite end 27b) of the first heat exchanging portion 26a was 39°C. Also, the temperature of the liquid coolant at an inlet side (the end 28a) of the second heat exchanging portion 26b of the primary manifold 11 was -3°C, the temperature of the liquid coolant at an outlet side (the opposite end 28b) of the second heat exchanging portion 26b was 0°C, and the temperature of the liquid coolant at an outlet side of the third heat exchanging portion 30 of the auxiliary manifold 24 was +2°C. At this time, the surface of the ice making plate 23 attained -10°C sufficient to make ice.

In order to realize such a high efficiency as discussed above, in the electric refrigerator of the present invention employing the thermoelectric module, the respective positions where the first and second circulating pumps 14a and 14b are disposed are properly selected and, at the same time, the first and second air traps 37a and 37b are employed to avoid air bubbles from being circulated during any of the heat radiating and heat absorbing cycles.

More specifically, the first circulating pump 14a used in the heat radiating cycle is, as shown in Figs. 3 and 7, disposed at a level higher than the heat-radiating heat exchanger 10 and the first heat exchanging portion 26a of the primary manifold 11. The air bubbles entering the heat radiating cycle are collected in the vicinity of a suction port 35 of the first circulating pump 14a disposed above the heat radiating cycle and are, during the drive of the first circulating pump 14a, drawn into the first circulating pump 14a through the suction port 35 thereof, gathering at a center portion of a pump impeller within the first circulating pump 14a so that the air bubbles discharged from the discharge port 31 of the first circulating pump 14a can be reduced, whereby the amount of the air bubbles being circulated in the heat radiating cycle is reduced. It is to be noted that the first air trap 37a is contracted to the solid-lined position as shown in Fig. 9 during the drive of the first circulating pump 14a.

When the first circulating pump 14a is brought to a halt, the air bubbles gathering at the center portion of the pump impeller within the first circulating pump 14a float from the suction port 35 to the first air trap 37a and are then recovered in the first air trap 37a. Reference numeral 42 represents a top surface of the liquid coolant within the first air trap 37a.

Also, when the first circulating pump 14a is brought to a halt, the first air trap 37a expands to the phantom-lined position shown in Fig. 9 to cause the air bubbles, then floating upwardly from the suction port 35, to be positively recovered in the first air trap 37a.

The second circulating pump 14b used in the heat absorbing cycle is, as shown in Figs. 3 and 8, disposed at a level higher than the cooling heat exchanger 20 and the second heat exchanging portion 26b of the primary manifold 11. The air bubbles entering the heat absorbing cycle are collected in the vicinity of a suction port 40 of the second circulating pump 14b disposed at a high position as is the case with the heat radiating cycle, gathered at a center portion of a pump impeller within the second circulating pump 14b and the amount of the air bubbles being circulated in the heat absorbing cycle is consequently reduced. When the second circulating pump 14b is brought to a halt, the second air trap 37b, as is the case with the first air trap 37a, expands to the phantom-lined position as shown in Fig. 9 to allow the air bubble floating upwardly from the suction port 40 to be positively recovered by the second air trap 37b.

The first and second air traps 37a and 37b also serve to regulate the pressure inside the pipings used for the heat radiating and heat absorbing cycles, respectively. While increase in pressure inside the pipings may result in immediate leakage of liquid at points of connection of the pipings in the circulating passages, the first and second air traps 37a and 37b employed in the electric refrigerator of the type employing the thermoelectric module according to the present invention expand in response to the pressure inside the piping during the drive of the first and second circulating pumps 14a and 14b to thereby prevent the pressure inside the pipings from being increased.

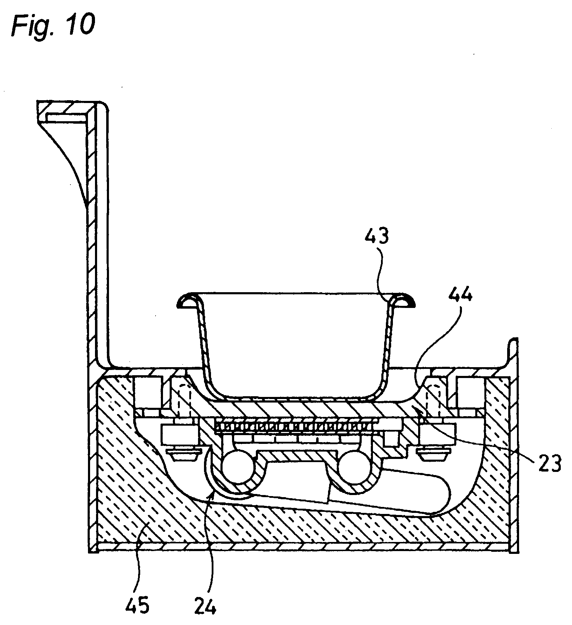

Also, in the electric refrigerator of the type employing the thermoelectric module according to the present invention, since the auxiliary manifold 24 is employed in the indoor chamber 17 separate from the primary manifold 11 so that the radiating surface of the auxiliary manifold 24 can undergo a heat exchange with the liquid coolant in the heat absorbing cycle, the ice making plate 23 could be sufficiently cooled. Fig. 10 illustrates the details of the auxiliary manifold 24, the ice making plate 23 and their related component parts. The ice making plate 23 made of aluminum has an upper surface formed with a recess 44 for accommodating an ice box 43 and/or storing waste water which would be produced when the refrigerator is set in a defrosting mode of operation. Reference numeral 45 represents a heat insulating material.

In the electric refrigerator of the type employing the thermoelectric module according to the present invention, the following structure is employed to minimize condensed water.

Since the liquid coolant of +2°C flows through the second circulating pump 14b for the heat absorbing cycle, condensation will occur if the second circulating pump 14b is disposed outside the indoor chamber. For this reason, the second circulating pump 14b is disposed inside the indoor chamber to eliminate condensation taking place on the surface of the second circulating pump 14b. Also, the fifth piping 32e connecting between the discharge port 38 of the second circulating pump 14b and the second heat exchanging portion 26b of the primary manifold 11 disposed outside the indoor chamber is so configured as to extend laterally downwardly of the cooling heat exchanger 20 within the machine chamber 19, then extend outwardly from the indoor chamber through the insulating material 8 at a location 46, as shown in Figs. 1 and 3, in the vicinity of the primary manifold 11 and is finally connected with the second heat exchanging portion 26b of the primary manifold 11. In this way, most of the fifth piping 32e is disposed inside the indoor chamber, which is 5°C in temperature, to thereby minimize occurrence of condensation of water.

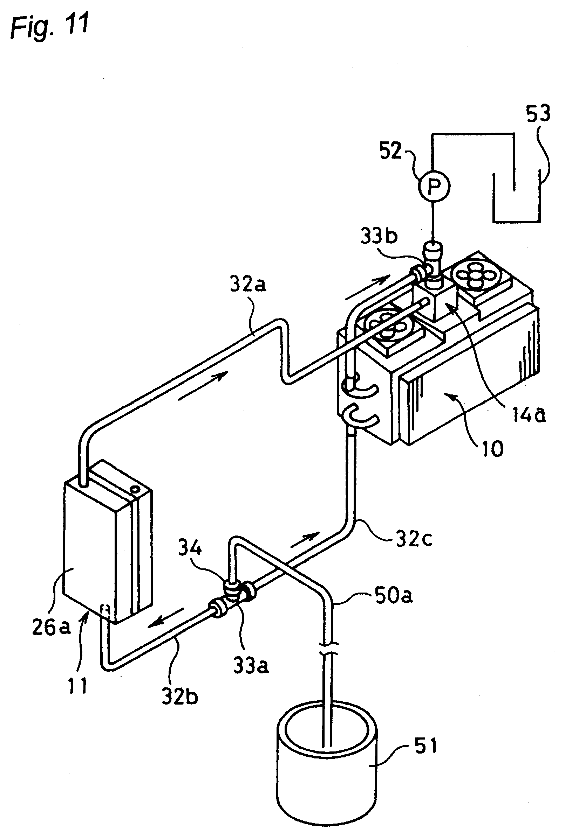

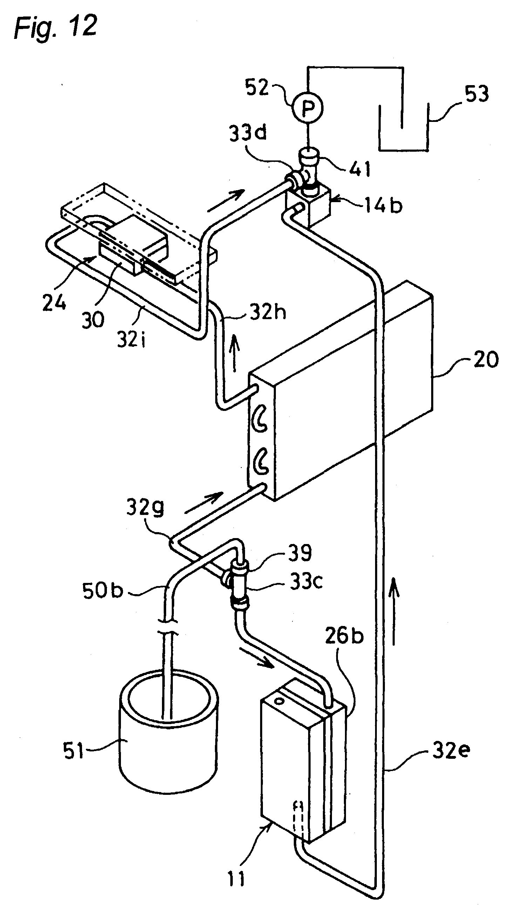

In this way, the electric refrigerator of the type employing the thermoelectric module is so constructed that bubbles, if any, which have got mixed in the circulating passage of liquid coolant can be collected into the first and second air traps 37a, 37b so that bubbles are prevented from circulating along with the liquid coolant. In filling the liquid coolant into the heat radiating cycle and the heat absorbing cycle, the liquid filling method as illustrated in Figs. 11 and 12 is carried out to ensure that the possibility of bubble inclusion during the coolant filling is minimized.

Fig. 11 illustrates the method of filling the liquid coolant into the heat radiating cycle.

During the filling operation, one end of a pipeline 50a is connected to the coupling port 34 of the T-shaped fluid coupler 33a interposed between the heat-radiating heat exchanger 10 and the first heat exchanging portion 26a of the primary manifold 11, and the other end of the pipeline 50a is immersed in the liquid coolant contained in a coolant tank 51. The suction port of the self-priming pump 52 is connected to the coupling port 36 of the T-shaped fluid coupler 33b attached to the suction port 35 of the first circulating pump 14a. Shown at 53 is a tank for receiving the liquid coolant discharged from the discharge port of the self-priming pump 52. It may be arranged that the liquid coolant can return to the coolant tank 51 without provision of the tank 53.

When the self-priming pump 52 is operated under such condition of connection, the air in the circulating passage of the heat radiating cycle is sucked and the pressure in the pipeline is gradually reduced, so that the liquid coolant in the coolant tank 51 is sucked through the pipeline 50a and the T-shaped fluid coupler 33a to flow into the circulating passage of the heat radiating cycle. At this moment, since the resistance to flow within the pipeline extending from the T-shaped fluid coupler 33a to the first circulating pump 14a via the heat-radiating heat exchanger 10 is substantially equal to the resistance to flow within the pipeline extending from the T-shaped fluid coupler 33a to the first circulating pump 14a via the first heat exchanging portion 26a of the primary manifold 11, the liquid coolant entering from the T-shaped fluid coupler 33a is gradually sucked from both the passage passing through the heat-radiating heat exchanger 10 and the passage passing through the first beat exchanging portion 26a of the primary manifold 11, and not from only one of the two passages.

When the self-priming pump 52 has been operated continuously over a predetermined time period after the discharge of the liquid coolant from the discharge port of the self-priming pump 52, operation of the self-priming pump 52 is stopped. Under this condition, the pipeline 50a is removed from the coupling port 34 of the T-shaped fluid coupler 33a. At this moment, because the coupling port 36 of the T-shaped fluid coupler 33b is blocked by the self-priming pump 52, even if the pipeline 50a is removed, there will occur no back flow of the liquid coolant from the coupling port 34 of the T-shaped fluid coupler 33a. The coupling port 34 from which the pipeline 50a is removed is closed with a cap.

Next, the self-priming pump 52 is removed from the coupling port 36 of the T-shaped fluid coupler 33b, and the first air trap 37a is mounted in position, so that the coupling port for connection between the heat radiating cycle and the self-priming pump 52 is closed. The filling operation has now been completed.

With the self-priming pump 52 connected in this way, the liquid coolant can be gradually filled in the heat radiating cycle with little bubble inclusion. Hence, there is no possibility of any substantial impact being exerted upon the connecting portion of the pipeline. Also, there is no possibility of coolant leaks, and stable refrigerator operation can be expected over a long period of time. Further, the pipeline 50a and the self-priming pump 52 are easy to remove, and provide good operability.

Fig. 12 illustrates the method of filling a liquid coolant into the heat absorbing cycle.

This method is similar to that in the case of heat radiating cycle. During the filling operation, one end of a pipeline 50b is connected to the coupling port 39 of the T-shaped fluid coupler 33c interposed between the cooling heat exchanger 20 and the second beat exchanging portion 26b of the primary manifold 11, and the other end of the pipeline 50b is immersed in the liquid coolant contained in the coolant tank 51. The suction port of the self-priming pump 52 is connected to the coupling port 41 of the T-shaped fluid coupler 33d attached to the suction port 40 of the second circulating pump 14b. Shown at 53 is a tank for receiving the liquid coolant discharged from the discharge port of the self-priming pump 52. It may be arranged that the liquid coolant can return to the coolant tank 51 without provision of the tank 53.

When the self-priming pump 52 is operated under such condition of connection, the air in the circulating passage of the heat absorbing cycle is sucked and the pressure in the pipeline is gradually reduced, so that the liquid coolant in the coolant tank 51 is sucked through the pipeline 50b and the T-shaped fluid coupler 33c to flow into the circulating passage of the heat absorbing cycle. In this case, because the resistance to flow within the pipeline extending from the T-shaped fluid coupler 33c to the second circulating pump 14b via the second heat exchanging portion 26b of the primary manifold 11 is substantially equal to the resistance to flow within the pipeline extending to the second circulating pump 14b via the heat-radiating heat exchanger 20 and the third heat exchanging portion 30 of the auxiliary manifold 24, the liquid coolant entering from the T-shaped fluid coupler 33c is gradually sucked from both the passage passing through the second heat exchanging portion 26b of the primary manifold 11 and the passage passing through the cooling heat exchanger 20, and not from only one of the two passages.

When the self-priming pump 52 has been operated continuously over a predetermined time period after the discharge of the liquid coolant from the discharge port of the self-priming pump 52, operation of the self-priming pump 52 is stopped. Under this condition, the pipeline 50b is removed from the coupling port 39 of the T-shaped fluid coupler 33c. At this moment, because the coupling port 41 of the T-shaped fluid coupler 33d is blocked by the self-priming pump 52, even if the pipeline 50b is removed, there will occur no back flow of the liquid coolant from the coupling port 39 of the T-shaped fluid coupler 33c. The coupling port 39 from which the pipeline 50b is removed is closed with a cap.

Next, the self-priming pump 52 is removed from the coupling port 36 of the T-shaped fluid coupler 33d, and the second air trap 37b is mounted in position, so that the coupling port for connection between the heat radiating cycle and the self-priming pump 52 is closed. The filling operation has now been completed.

With the self-priming pump 52 connected in this way, the liquid coolant can be gradually filled in the heat radiating cycle with little bubble inclusion. Hence, there is no possibility of any substantial impact being exerted upon the connecting portion of the pipeline. Also, there is no possibility of coolant leaks, and stable refrigerator operation can be expected over a long period of time. Further, the pipeline 50b and the self-priming pump 52 are easy to remove, and provide good operability.

### (Embodiment 2)

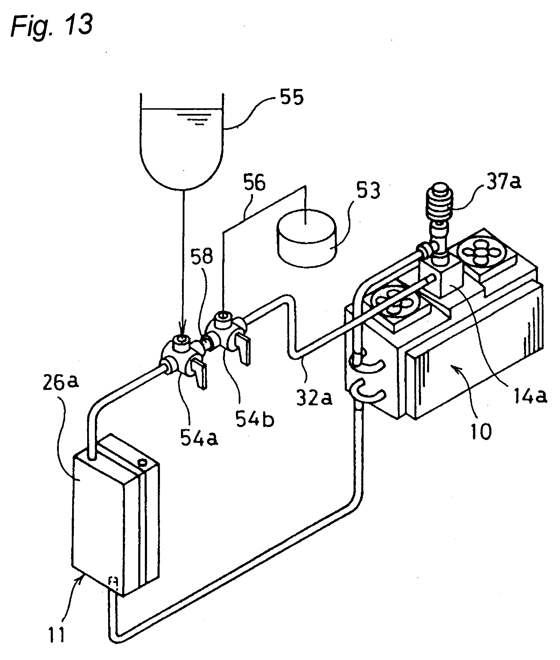

Figs. 13 to 15 illustrate Embodiment 2.

In the following description, parts having functions similar to those in Embodiment 1 are designated by like reference numerals.

Embodiment 2 differs from Embodiment 1 in that first and second three-way valves are arranged in series in a circulating passage and coolant filling is carried out at the position of the first and second three-way valves.

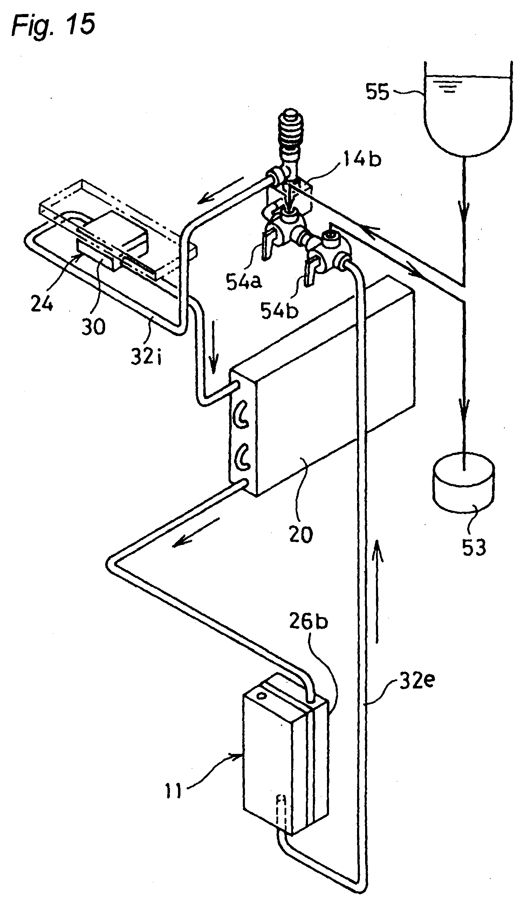

Specifically, in the heat radiating cycle, the first and second three-way valves 54a, 54b are interposed in series midway of the length of a first piping 32a, as shown in Fig. 13. In the heat absorbing cycle, as shown in Fig. 15, the first and second three-way valves 54a, 54b are interposed in series midway of the length of the fifth piping 32e.

Because the liquid filling method using the first and second three-way valves 54a, 54b is the same for both the heat radiating cycle and the heat absorbing cycle, description is made with respect to the heat radiating cycle.

As shown in Fig. 13, a liquid coolant is supplied to a port P1 of the first three-way valve 54a disposed in the heat radiating cycle from a liquid reservoir 55 held at a location above the port. A port P1 of the second three-way valve 54b is open to the tank 53 through a pipeline 56.

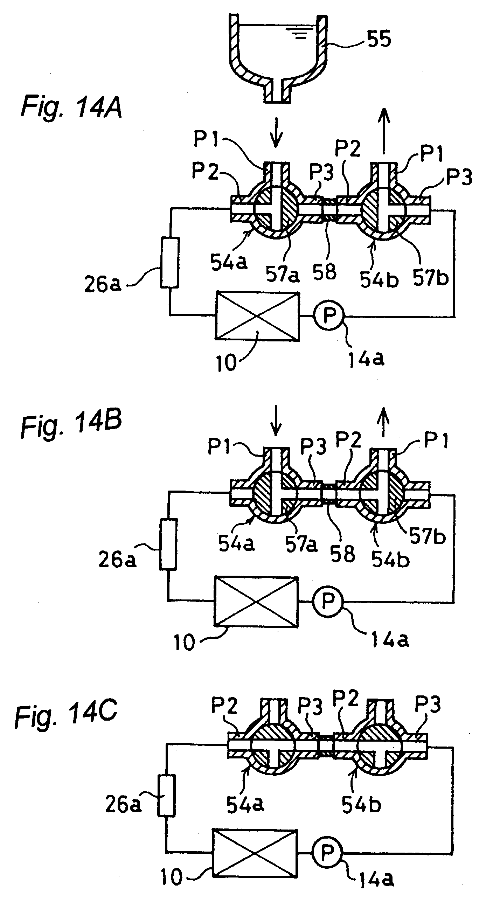

First, valve bodies 57a, 57b of the first and second three-way valves 54a, 54b are respectively switched over, as shown in Fig. 14A. The valve body 57a is in a switched-over condition to allow communication between the ports P1 and P2 of the first three-way valve 54a. The valve body 57b is in a switched-over condition to allow communication between the ports P1 and P3 of the second three-way valve 54b.

Under this condition, the liquid coolant which has flowed down spontaneously from the liquid reservoir 55 flows into the port P3 of the second three-way valve 54b through the first heat exchanging portion 26a of the primary manifold 11, the heat-radiating heat exchanger 10, and the first circulating pump 14a, and then flows down spontaneously into the tank 53 through the port P1 of the second three-way valve 54b and the pipeline 56. That is, with the exception of a piping 58 which interconnects the port P3 of the first three-way valve 54a and the port P2 of the second three-way valve 54b, all portions are under the condition to permit the liquid coolant to flow.

Next, the valve bodies 57a, 57b of the first and second three-way valves 54a, 54b are respectively switched over, as shown in Fig. 14B. The valve body 57a is in a switched-over condition to allow communication between the ports P1 and P3 of the first three-way valve 54a. The valve body 57b is in a switched-over condition to allow communication between the ports P1 and P2 of the second three-way valve 54b. Therefore, the liquid coolant which has flowed down spontaneously from the liquid reservoir 55 flows from the port P3 of the first three-way valve 54a into the port P2 of the second three-way valve 54b through the pipeline 58, and then flows down spontaneously into the tank 53 through the port P1 of the second three-way valve 54b and the pipeline 56. Under the condition shown in Fig. 14B to which the first and second three-way valves 54a, 54b have been switched over from the condition shown in Fig. 14A, the passage which extends from the first three-way valve 54a to the second three-way valve 54b through the first heat exchanging portion 26a of the primary manifold 11, the heat-radiating heat exchanger 10, and the first circulating pump 14a, is filled with the liquid coolant.

Next, the valve bodies 57a, 57b of the first and second three-way valves 54a, 54b are respectively switched over, as shown in Fig. 14C. The valve body 57a is in a switched-over condition to allow communication between the ports P2 and P3 of the first three-way valve 54a. The valve body 57b is in a switched-over condition to allow communication between the ports P2 and P3 of the second three-way valve 54b. Therefore, the first heat exchanging portion 26a of the primary manifold 11 and the first circulating pump 14a are made to communicate with each other through the first and second three-way valves 54a, 54b. The filling operation is thus completed. Finally, the liquid reservoir 55, the piping 56, and the tank 53 are removed.

According to this filling method, a mere switch-over control of the valve bodies 57a, 57b of the first and second three-way valves 54a, 54b allows the liquid coolant to be filled gradually into the heat radiating cycle with reduced bubble inclusion. Therefore, the connecting portion of the pipeline is not liable to the effect of any substantial impact, no possibility of coolant leakage is involved, and stable refrigerator operation can be expected over a long time period. Further, such operation required in the case of Embodiment 1 as closing the T-shaped fluid coupler 33a and the coupling port 34 with the use of a cap is not required.

Although in this Embodiment 2 coolant filling is carried out by allowing the liquid coolant to flow down spontaneously from the liquid reservoir 55, it is possible to carry out the filling operation by supplying the liquid coolant under pressure from the port P1 of the first three-way valve 54a, or by connecting the port P1 of the first three-way valve 54a to the coolant tank and connecting a self-priming pump to the port P1 of the second three-way valve 54b, to thereby drawn up the liquid coolant.

In the foregoing embodiments, immediately upon completion of setting for coolant filling, the filling operation is commenced by supplying the liquid coolant into the circulating passage. However, prior to the start of coolant filling, a pretreatment liquid for improving the inner surface condition of the circulating passages may be drawn into the circulating passages by operating a self-priming pump, and thereafter coolant filling is carried out. By so doing, it is possible to further reduce bubble inclusion in the circulating passages.

Specifically, a silica-containing acrylic resin coating is used as the pretreatment liquid. The use of such a pretreatment agent can eliminate any surface irregularity of the circulating passages, so that the surface can be smoothed to a surface roughness of 10 µm. As a result, it is possible to perform liquid filling under the condition in which surface irregularities have been eliminated and bubble adhesion has been substantially reduced.

A surface active agent may also be used as a pretreatment agent. In this case, the surface active agent acts to improve the inner surface wettability of the circulating passages. When coolant filling is commenced after such pretreatment, the liquid coolant adapts itself to the inner surface of the circulating passages during its movement. Thus, liquid filling can be performed under the condition in which bubble adhesion has been substantially reduced.

In the foregoing embodiments, a Peltier element as a thermoelectric module is employed in an electric refrigerator, and the liquid coolant is supplied to the first and second heat exchanging portions. Such arrangement is applicable to thermoelectric refrigeration systems other than refrigerators as well. Also, it is possible to supply the liquid coolant to either the first or second heat exchanging portion.

As described above, according to the present invention, liquid filling into the circulating passages is performed by drawing up the liquid coolant with the use of a self-priming pump, by causing the liquid coolant to flow downwardly, or by feeding the liquid coolant under pressure. Therefore, the filling method does not require any such mechanical strength with respect to the circulating passages as is greater than that necessary for normal refrigerator operation, and yet enables coolant filling with less bubble inclusion involved. The method can thus contribute to realization of an electric refrigerator having a high thermal efficiency.

Further, prior to the start of a liquid filling operation, by driving a self-priming pump to pump a pretreatment liquid for improving the inner surface condition of the circulating passages, and by subsequently drawing up the liquid coolant, it is possible to further reduce bubble inclusion into the circulating passages.

## Claims

1. In a thermoelectric refrigeration system including a first heat exchanging portion thermally coupled to a heat radiating surface of a thermoelectric module, a second heat exchanging portion thermally coupled to a cooling surface of the thermoelectric module, and a circulating passage defined by a circulating pump, a heat-radiating heat exchanger and the first heat exchanging portion, with a liquid filled in the circulating passage to form a heat radiating system, a liquid filling method comprising:
when the circulating passage is filled with the liquid, connecting to a liquid tank a liquid suction port between the heat-radiating heat exchanger and the first heat exchanging portion, connecting a self-priming pump to a suction port or discharge port of the circulating pump in series, operating the self-priming pump to draw the liquid from the liquid tank through the circulating passage, stopping the operation of the self-priming pump after the liquid has reached a discharge port of the self-priming pump, closing the liquid suction port, removing the self-priming pump, and closing a coupling port between the self-priming pump and the circulating passage.

2. In a thermoelectric refrigeration system including a first heat exchanging portion thermally coupled to a heat radiating surface of a thermoelectric module, a second heat exchanging portion thermally coupled to a cooling surface of the thermoelectric module, and a circulating passage defined by a circulating pump, a cooling heat exchanger and the second heat exchanging portion, with a liquid filled in the circulating passage to form a heat absorbing system, a liquid filling method comprising:
when the circulating passage is filled with the liquid, connecting to a liquid tank a liquid suction port between the cooling heat exchanger and the second heat exchanging portion, connecting a self-priming pump to a suction port or discharge port of the circulating pump in series, operating the self-priming pump to draw the liquid from the liquid tank through the circulating passage, stopping the operation of the self-priming pump after the liquid has reached a discharge port of the self-priming pump, closing the liquid suction port, removing the self-priming pump, and closing a coupling port between the self-priming pump and the circulating passage.

3. In a thermoelectric refrigeration system including: a manifold having a first heat exchanging portion thermally coupled to a heat radiating surface of a thermoelectric module and a second heat exchanging portion thermally coupled to a cooling surface of the thermoelectric module; a first circulating passage defined by a first circulating pump, a heat-radiating heat exchanger and the first heat exchanging portion of the manifold, with a liquid filled in the interior of the first circulating passage to form a beat radiating system; and a second circulating passage defined by a second circulating pump, a cooling heat exchanger and the second heat exchanging portion of the manifold, with a liquid filled in the interior of the second circulating passage to form a heat absorbing system, a liquid filling method comprising:
when one of the circulating passages is filled with the liquid, connecting to a liquid tank a liquid suction port between the heat exchanger and the heat exchanging portion of the manifold, connecting a self-priming pump to a suction port or discharge port of the circulating pump, operating the self-priming pump to draw the liquid from the liquid tank through the circulating passage, stopping the operation of the self-priming pump after the liquid has reached a discharge port of the self-priming pump, closing the liquid suction port, removing the self-priming pump, and closing a coupling port between the self-priming pump and the circulating passage.

4. In a thermoelectric refrigeration system including a first heat exchanging portion thermally coupled to a heat radiating surface of a thermoelectric module, a second heat exchanging portion thermally coupled to a cooling surface of the thermoelectric module, and a circulating passage defined by a circulating pump, a heat-radiating heat exchanger and the first heat exchanging portion, with a liquid filled in the interior of the circulating passage to form a heat radiating system, a liquid filling method comprising:
when the circulating passage is filled with the liquid, arranging a first three-way valve and a second three-way valve in series in the circulating passage, causing the liquid to flow from the first three-way valve through the circulating passage and the second three-way valve under the condition in which no communication between the first and second three-way valves is allowed, switching the first and second three-way valves to close the circulating passage so that the liquid is prevented from flowing into and out of the circulating passage, thus allowing the liquid to flow from the first three-way valve to the second three-way valve to fill the liquid in a connecting pipeline between the first three-way valve and the second three-way valve, and further switching the first and second three-way valves so that the circulating passage is formed with the first and second three-way valves before liquid filling is completed.

5. In a thermoelectric refrigeration system including a first heat exchanging portion thermally coupled to a heat radiating surface of a thermoelectric module, a second heat exchanging portion thermally coupled to a cooling surface of the thermoelectric module, and a circulating passage defined by a circulating pump, a cooling heat exchanger and the second heat exchanging portion, with a liquid filled in the interior of the circulating passage to form a heat absorbing system, a liquid filling method comprising:
when the circulating passage is filled with the liquid, arranging a first three-way valve and a second three-way valve in series in the circulating passage, causing the liquid to flow from the first three-way valve through the circulating passage and the second three-way valve under the condition in which no communication between the first and second three-way valves is allowed, switching the first and second three-way valves to close the circulating passage so that the liquid is prevented from flowing into and out of the circulating passage, thus allowing the liquid to flow from the first three-way valve to the second three-way valve to fill the liquid in a connecting pipeline between the first three-way valve and the second three-way valve, and further switching the first and second three-way valves so that the circulating passage is formed with the first and second three-way valves before liquid filling is completed.

6. In a thermoelectric refrigeration system including: a manifold having a first heat exchanging portion thermally coupled to a heat radiating surface of a thermoelectric module and a second heat exchanging portion thermally coupled to a cooling surface of the thermoelectric module; a first circulating passage defined by a first circulating pump, a heat-radiating heat exchanger and the first heat exchanging portion of the manifold, with a liquid filled in the interior of the first circulating passage to form a heat radiating system; and a second circulating passage defined by a second circulating pump, a cooling heat exchanger and the second beat exchanging portion of the manifold, with a liquid filled in the interior of the second circulating passage to form a heat absorbing system, a liquid filling method comprising:
when the circulating passage is filled with the liquid, arranging a first three-way valve and a second three-way valve in series in the circulating passage, causing the liquid to flow from the first three-way valve through the circulating passage and the second three-way valve under the condition in which no communication between the first and second three-way valves is allowed, switching the first and second three-way valves to close the circulating passage so that the liquid is prevented from flowing into and out of the circulating passage, thus allowing the liquid to flow from the first three-way valve to the second three-way valve to fill the liquid in a connecting pipeline between the first three-way valve and the second three-way valve, and further switching the first and second three-way valves so that the circulating passage is formed with the first and second three-way valves before liquid filling is completed.

7. A liquid filling method in a thermoelectric refrigeration system as claimed in any one of claims 1 to 6, wherein prior to start of the liquid filling operation, a self-priming pump is operated to draw up a pretreatment liquid for improving an inner surface condition of the circulating passage, and the liquid is then drawn up to thereby complete the liquid filling operation.

8. A liquid filling method in a thermoelectric refrigeration system as claimed in claim 7, wherein a silica-containing acrylic resin coating is used as the pretreatment liquid.

9. A liquid filling method in a thermoelectric refrigeration system as claimed in claim 7, wherein a surface active agent is used as the pretreatment liquid.
